# EUROPEAN PATENT APPLICATION

(11) **EP 2 360 724 A1**
(43) Date of publication of application: **24.08.2011**
(21) Application number: 10001513.0
(22) Date of filing: 15.02.2010
(51) Int. Cl.: H01L 23/367

(54) **Heat dissipation structure having combined cooling fins**

(71) Applicant: SUN-LITE SOCKETS INDUSTRY INC., Kuei Shan Hsiang T'ao yuan (TW)
(72) Inventor: Chen, Tsan-Chi, Chung Ho City Taipei Hsien (TW)
(74) Representative: Karakatsanis, Georgios

(57) **Abstract**

The present invention relates to a heat dissipation structure comprising a metal base and a plurality of cooling fins, wherein the metal base is formed with a receiving space therein for receiving a heat generating object, an outer surface of the metal base is equidistantly formed with a plurality of recesses, each of the cooling fins is formed by a U-shaped metal plate including two heat dissipation portions and an elastic engagement portion, the elastic engagement portion is in U-shape and has two ends connected to one end of each of the two heat dissipation portions respectively, and an outer surface of the elastic engagement portion can be engaged with an inner surface of each of the recesses by the resilience thereof, so as to efficiently increase the amount and heat dissipation area of the cooling fins and greatly enhance the heat dissipation efficiency of the heat dissipation structure.

## Description

### FIELD OF THE INVENTION

The present invention relates to a heat dissipation structure, and more particularly to a heat dissipation structure comprising a metal base and a plurality of cooling fins, wherein the metal base is formed with a receiving space therein for receiving a heat generating object, an outer surface of the metal base is equidistantly formed with a plurality of recesses, each of the cooling fins includes two heat dissipation portions and an elastic engagement portion, and an outer surface of the elastic engagement portion can be engaged with an inner surface of each of the recesses by the resilience thereof, Therefore, the present invention not only can efficiently increase the amount of the cooling fins and the direct contact area between the heat dissipation structure and the ambient atmosphere so as to enhance the heat dissipation efficiency of the heat dissipation structure, but also can efficiently simplify the installation process of the cooling fins without needing the welding process and using the welding materials so as to greatly reduce the cost of the welding process and materials and make the installation process thereof to be more clean and environment-friendly than the conventional welding process.

### BACKGROUND OF THE INVENTION

Recently, with the advance of technologies, the energy demand is continuously increased, so that people are paying more attention to the environmental protection issues about energies. In comparison with traditional bulbs or lamps, a light emitting diode (LED) has several advantages including smaller volume, saving energy, longer usage life and excluding toxic substance, such as mercury (Hg). Thus, LEDs are accepted by more and more people day by day. However, because the luminous efficiency of an LED lamp is in direct proportion to heat generated by the LED lamp, meaning that an LED lamp having higher brightness will generate more waste heat, so as to cause the damage of the LED lamp. In addition, after a lamp holder of the LED lamp is long-term used under considerable waste heat, there will be some serious problems including material aging and light attenuation resulting in shortening the usage life of the lamp holder. Therefore, to solve the foregoing problems, manufacturers correspondingly develop various heat dissipation structures (i.e. heat sinks) to enhance the heat dissipation efficiency of the lamp holder. For example, a traditional heat dissipation structure is described hereinafter.

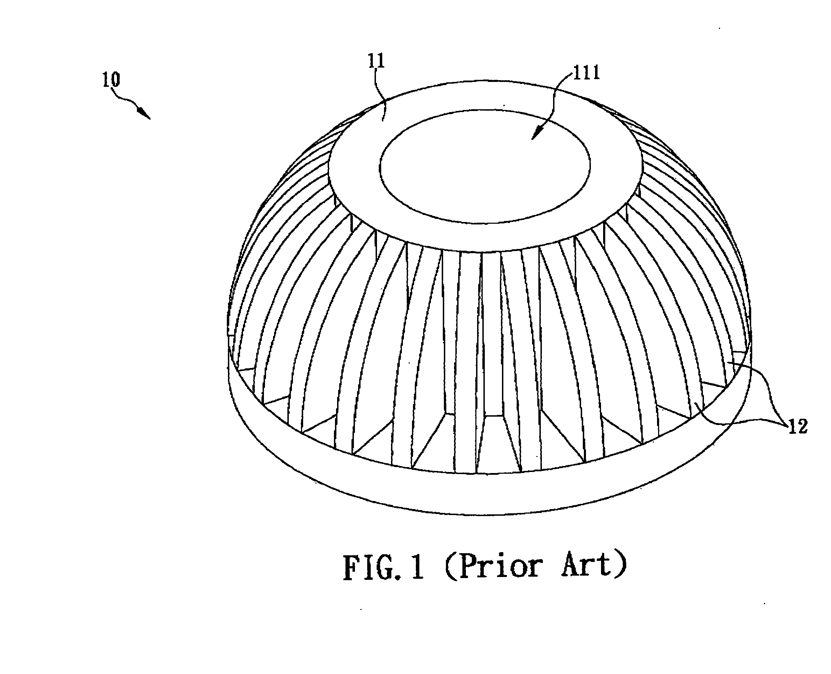

Referring now to FIG 1, a traditional heat dissipation structure 10 is illustrated, wherein the traditional heat dissipation structure 10 is integrally formed by extruding a metal material through a metal extruder, and comprises a base 11 and a plurality of cooling fins 12. The base 11 is formed with a receiving space 111 therein for receiving a light emitting lamp (i.e. a heat generating object). The cooling fins 12 are arranged around an outer surface of the base 11, so that heat generated by the light emitting lamp (the heat generating object) can be transferred from the base 11 to the cooling fins 12 and finally dissipated into ambient atmosphere around the cooling fins 12.

However, because the traditional heat dissipation structure 10 is integrally formed by extruding a metal material through a metal extruder, the thickness of the cooling fins 12 formed by an extrusion process is generally too thick due to the limitation of current technology of the extrusion process. As a result, the amount of the cooling fins 12 on the base 11 and the contact area between the cooling fins 12 and the ambient atmosphere may be insufficient, such that heat generated by the light emitting lamp (the heat generating object) in the traditional heat dissipation structure 10 can not be efficiently dissipated out of the base 11. Thus, the operational temperature of the traditional heat dissipation structure 10 may continuously increase to cause the damage of the heat generating object.

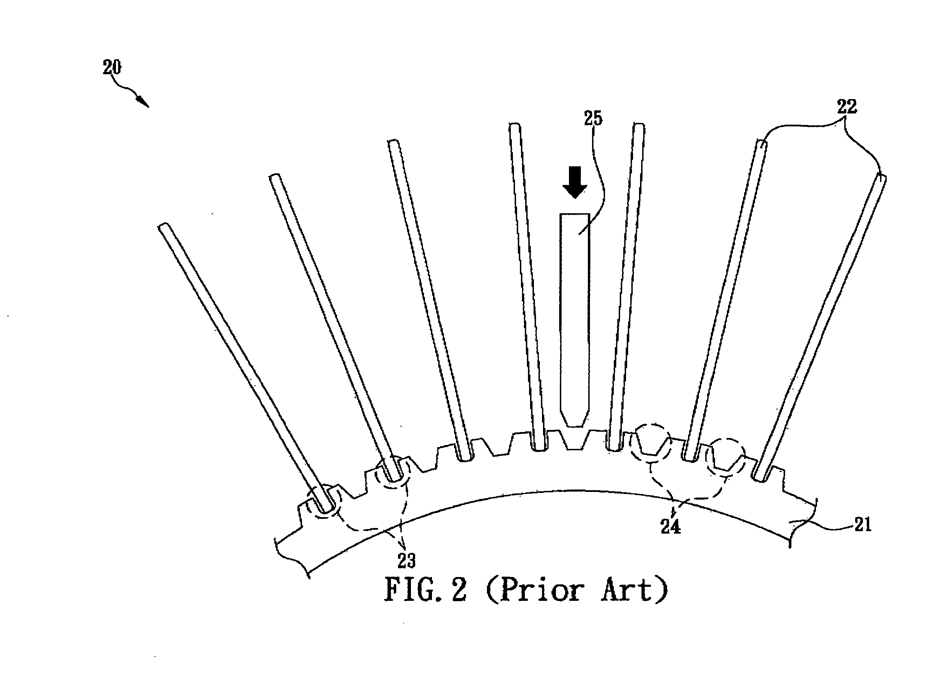

To solve the foregoing problems, manufacturers further developed another heat dissipation structure to enhance the heat dissipation efficiency of the lamp holder. Referring now to FIG. 2, a heat dissipation structure 20 is illustrated and comprises an annular lamp holder 21 and a plurality of cooling fins 22, wherein the annular lamp holder 21 can be used to receive a light emitting lamp (i.e. a heat generating object) therein and an outer surface of the annular lamp holder 21 is formed with a plurality of recess 23 and a plurality of grooves 24, both of which are alternatively arranged on the outer surface. In assembly, one end of each of the cooling fins 22 can be inserted into each of the recesses 23, respectively. Then, a press tool 25 is used to press each of the grooves 24, so that two sides of the end of each of the cooling fins 22 are pushed by two of the adjacent grooves 24 close thereto. As a result, the end of each of the cooling fins 22 is engaged in each of the recesses 23, so that the annular lamp holder 21 and the cooling fins 22 can be tightly combined into one piece.

However, because the cooling fins 22 of the heat dissipation structure 20 are combined with the annular lamp holder 21 by the foregoing pressing and engaging processes, the annular lamp holder 2X must be formed with the grooves 24. But, the grooves 24 occupy some surface area of the annular lamp holder 21 where originally can be used to install the cooling fins 22, so that the amount of the cooling fins 22 on the annular lamp holder 21 will be limited. As a result, the amount of the cooling fins 22 on the annular lamp holder 21 and the contact area between the cooling fins 22 and the ambient atmosphere will be insufficient, such that heat generated by the light emitting lamp (the heat generating object) in the traditional heat dissipation structure 20 can not be efficiently dissipated out of the traditional heat dissipation structure 20.

As described above, it is important for various manufacturers and designers of lamps to think how to develop an innovative heat dissipation structure having a plurality of cooling fins which are formed by punching a one-piece metal plate or casting and can be engaged into surfaces of recesses of a metal base by the resilience of elastic engagement portions of the cooling fins, so as to solve the problem of the traditional heat dissipation structure which must be formed with the grooves on the metal base, and to increase the surface area of the metal base for combining with the cooling fins and the amount of the cooling fins, for the purpose of increasing the direct contact area between the heat dissipation structure and the ambient atmosphere and efficiently enhancing the heat dissipation efficiency of the heat dissipation structure.

It is therefore tried by the inventor to develop a heat dissipation structure having combined cooling fins to solve the foregoing problems existing in the traditional heat dissipation structure, as described above.

### BRIEF SUMMARY OF THE INVENTION

An object of the present invention is to provide a heat dissipation structure having combined cooling fins, which comprises a metal base and a plurality of cooling fins, wherein the metal base is formed with a receiving space therein for receiving a heat generating object (such as a light emitting lamp, a computer CPU, a transformer, etc.), and an outer surface of the metal base is equidistantly formed with a plurality of recesses. Furthermore, each of the cooling fins is formed by punching and bending a one-piece metal plate to be a U-shaped structure, while each of the cooling fins includes two heat dissipation portions and an elastic engagement portion, wherein each of the two heat dissipation portions is a planar plate, and the elastic engagement portion is a U-shaped plate. Two ends of the elastic engagement portion have resilience, and the two ends thereof are connected to one end of each of the two heat dissipation portions, respectively. In addition, the two ends of the elastic engagement portion can be pressed to be close to each other, so that the elastic engagement portion will be deformed for being inserted and received in each of the recesses. Meanwhile, an outer surface of the elastic engagement portion can be engaged with an inner surface of each of the recesses of the metal base by the resilience of the elastic engagement portion, so that heat generated by the heat generating object can be transferred from the metal base to the cooling fins. Therefore, the heat generated by the heat generating object can be rapidly transferred from the metal base to the cooling fins, and then dissipated to the ambient atmosphere through the cooling fins. In the traditional heat dissipation structure, one end of each of the cooling fins must be firstly inserted into each of the recesses of the annular lamp holder and then each of the grooves formed between two of the adjacent recesses is pressed by a press tool, so that two sides of the end of each of the cooling fins are pushed by two of the adjacent pressed grooves close thereto, and then the end of each of the cooling fins is engaged in each of the recesses for tightly combining the annular lamp holder and the cooling fins into one piece. In contrast, according to the heat dissipation structure having the combined cooling fins of the present invention, the outer surface of the elastic engagement portion can be engaged with the inner surface of each of the recesses of the metal base by the resilience of the elastic engagement portion without using the pressing and engaging processes to combine each of the cooling fins, so as to solve the problem of the traditional heat dissipation structure which must be formed with the grooves on the metal base, and to increase the surface area of the metal base for combining with the cooling fins and the amount of the cooling fins, for the purpose of increasing the amount of the cooling fins of the present invention which is more than twice of that of the traditional heat dissipation structure. As a result, the present invention can efficiently increase the amount of the cooling fins and the direct contact area between the heat dissipation structure and the ambient atmosphere. Therefore, the heat dissipation efficiency of the heat dissipation structure can be substantially enhanced, the entire heat dissipation effect of the heat dissipation structure can be improved, and the usage life of the heat generating object in the heat dissipation structure can be elongated. In addition, due to thermal expansion and contraction, when the elastic engagement portion absorbs more heat, the resilience of the elastic engagement portion correspondingly increases, so that the contact between the outer surface of the elastic engagement portion and the inner surface of the recess of the metal base becomes tighter, meaning that the heat conduction and the heat dissipation effect will be correspondingly enhanced. In other words, except for solving the problem of the traditional heat dissipation structure which must be formed with the grooves on the metal base, the present invention also simplify the installation process of the cooling fins, so as to efficiently increase the amount of the cooling fins on the metal base and the contact area between the cooling fins and the metal base.

### BRIEF DESCRIPTION OF THE SEVERAL VIEWS OF THE DRAWINGS

The structure and the technical means adopted by the present invention to achieve the above and other objects can be best understood by referring to the following detailed description of the preferred embodiments and the accompanying drawings, wherein
FIG. 1 is a perspective view of a traditional heat dissipation structure;
FIG. 2 is a cross-sectional view of the installation process of another traditional heat dissipation structure;
FIG. 3 is a perspective view of a heat dissipation structure having combined cooling fins according to a first preferred embodiment of the present invention; and FIG 4 is a cross-sectional view of a heat dissipation structure having combined cooling fins according to a second preferred embodiment of the present invention.

### DETAILED DESCRIPTION OF THE INVENTION

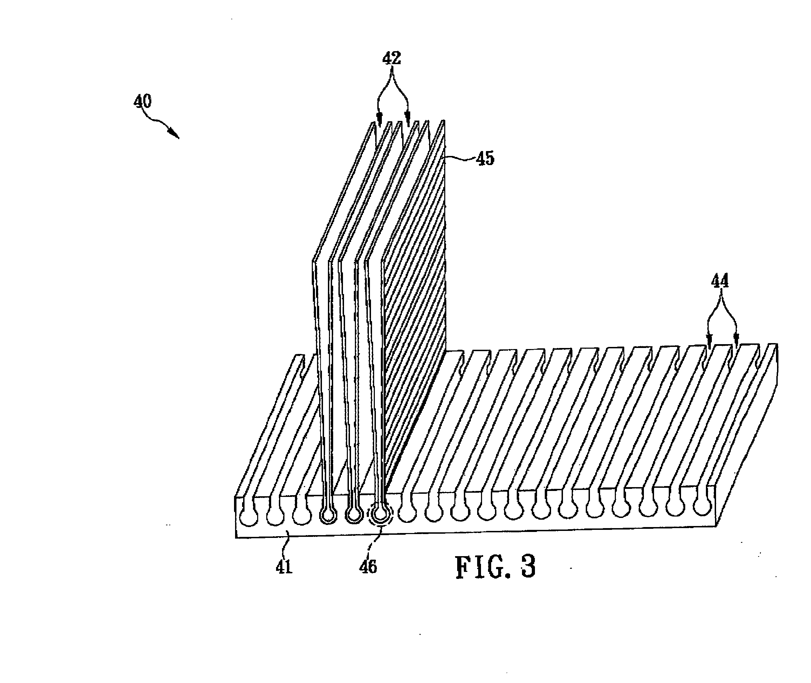

The present invention is related to a heat dissipation structure having combined cooling fins. Referring now to FIG. 3, a heat dissipation structure having combined cooling fins according to a first preferred embodiment of the present invention is illustrated. As shown, the heat dissipation structure designated by numeral 40 comprises a metal base 41 and a plurality of cooling fins 42, wherein a first surface of the metal base 41 (such as a lower surface) can be attached to one surface of a heat generating object (not shown, such as a light emitting lamp, a computer CPU, a transformer, etc.), and a second surface thereof (such as an upper surface) is equidistantly formed with a plurality of recesses 44. Each of the cooling fins 42 is formed by punching and bending a one-piece metal plate to form a U-shaped structure. Meanwhile, each of the cooling fins 42 includes two heat dissipation portions 45 and an elastic engagement portion 46, wherein each of the two heat dissipation portions 45 is a planar plate, and the elastic engagement portion 46 is a U-shaped plate. Two ends of the elastic engagement portion 46 have resilience, and the two ends thereof are integrally connected to one end of each of the two heat dissipation portions 45, respectively. In addition, the two ends of the elastic engagement portion 46 can be pressed to be close to each other, so that the elastic engagement portion 46 will be deformed for being inserted and received in a corresponding said recess 44. Meanwhile, an outer surface of the elastic engagement portion 46 can be engaged with an inner surface of the recess 44 of the metal base 41 by the resilience of the elastic engagement portion 46, so that heat generated by the heat generating object can be transferred from the metal base 41 to the cooling fins 42.

Therefore, the heat generated by the heat generating object can be rapidly transferred from the metal base 41 to the cooling fins 42, and then dissipated to the ambient atmosphere through the cooling fins 42. In the traditional heat dissipation structure, one end of each of the cooling fins must be firstly inserted into each of the recesses of the annular lamp holder and then each of the grooves formed between two of the adjacent recesses is pressed by a press tool, so that two sides of the end of each of the cooling fins are pushed by two of the adjacent pressed grooves close thereto, and then the end of each of the cooling fins is engaged in each of the recesses for tightly combining the annular lamp holder and the cooling fins into one piece. In contrast, according to the heat dissipation structure 40 having the combined cooling fins of the present invention, the outer surface of the elastic engagement portion 46 can be engaged with the inner surface of each of the recesses 44 of the metal base 41 by the resilience of the elastic engagement portion 46 without using the pressing and engaging processes to combine each of the cooling fins 42, so that the cooling fins 42 can be fixed on the outer surface of the metal base 41. Thus, the problem of the traditional heat dissipation structure which must be formed with the grooves on the metal base can be solved, while the surface area of the metal base 41 for combining with the cooling fins 42 and the amount of the cooling fins 42 can be increased. Meanwhile, the amount of the cooling fins 42 of the present invention can be increased and more than twice of that of the traditional heat dissipation structure. As a result, the present invention can efficiently increase the amount of the cooling fins 42 and the direct contact area between the heat dissipation structure 40 and the ambient atmosphere. Therefore, the heat dissipation efficiency of the heat dissipation structure 40 can be substantially enhanced, the entire heat dissipation effect of the heat dissipation structure 40 can be improved, and the usage life of the heat generating object in the heat dissipation structure 40 can be elongated. In addition, due to thermal expansion and contraction, when the heat generating object generates more heat and the elastic engagement portion 46 absorbs more heat to cause the volume expansion thereof, the resilience of the elastic engagement portion 46 will correspondingly increase, so that the contact between the outer surface of the elastic engagement portion 46 and the inner surface of the recess 44 of the metal base 41 becomes tighter, meaning that the heat conduction and the heat dissipation effect will be correspondingly enhanced. In other words, except for solving the problem of the traditional heat dissipation structure which must be formed with the grooves on the metal base 41, the present invention also simplifies the installation process of the cooling fins 42, so as to efficiently increase the amount of the cooling fins 42 on the metal base 41 and the contact area between the cooling fins 42 and the metal base 41.

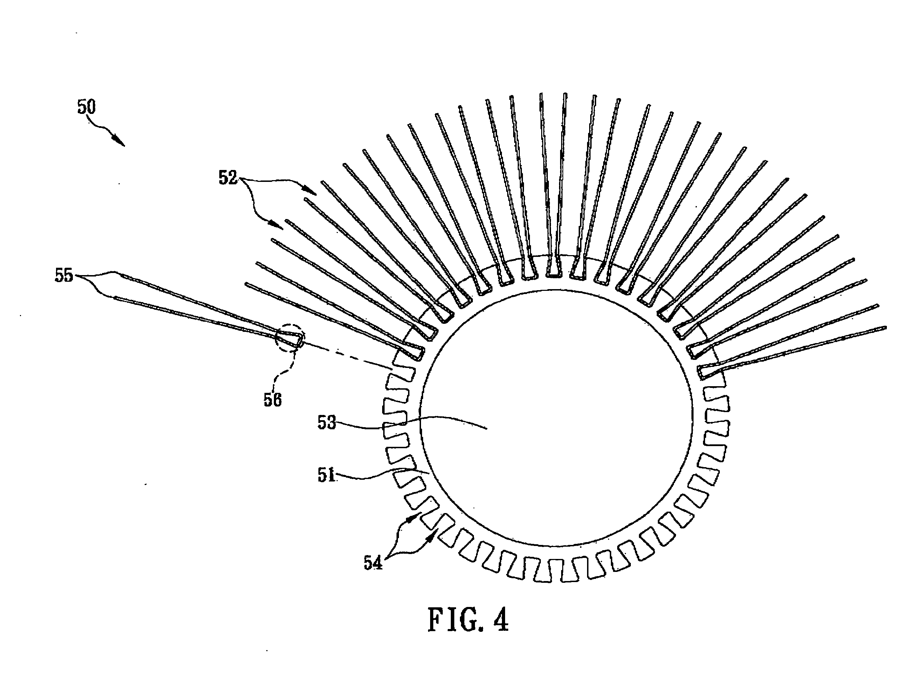

Referring now to FIG 4, in a second preferred embodiment of the present invention, a heat dissipation structure 50 comprises a metal base 51 and a plurality of cooling fins 52, wherein the metal base 51 and each of the cooling fins 52 are formed by punching a one-piece metal plate or casting, respectively. The metal base 51 is formed with a receiving space 53 for receiving a heat generating object (not shown, such as a light emitting lamp, a computer CPU, a transformer, etc.), and an outer surface of the metal base 51 is equidistantly formed with a plurality of recesses 54. Each of the cooling fins 52 includes two heat dissipation portions 55 and an elastic engagement portion 56, wherein each of the two heat dissipation portions 55 is a planar plate, and the elastic engagement portion 56 is a U-shaped plate. Two ends of the elastic engagement portion 56 have the resilience, and the two ends thereof are integrally connected to one end of each of the two heat dissipation portions 55, respectively. In addition, the two ends of the elastic engagement portion 56 can be pressed to be close to each other, so that the elastic engagement portion 56 will be deformed for being inserted and received in each of the recesses 54. Meanwhile, an outer surface of the elastic engagement portion 56 can be engaged with an inner surface of each of the recesses 54 of the metal base 51 by the resilience of the elastic engagement portion 56, so that heat generated by the heat generating object can be transferred from the metal base 51 to the cooling fins 52. Therefore, the present invention can simplify the installation process of the cooling fins 52, meaning that the two heat dissipation portions 55 can be positioned on the outer surface of the metal base 51 by one-step installation. Furthermore, the present invention can relatively reduce the desired amount of the recesses 54 on the metal base 51, and correspondingly increase the surface area of the metal base 51 for combining with the cooling fins 52 and the amount of the cooling fins 52. As a result, the manufacturer can one-step install the heat dissipation structure 50 on a production line by simpler and faster manufacturing process with lower manufacture cost, so as to carry out the purpose of reducing the manufacture cost of the heat dissipation structure 50.

Moreover, the cross-sectional profile of each of the recesses 54 is completely identical to the profile of the outer surface of the elastic engagement portion 56, while the profile of the outer surface of the elastic engagement portion 56 is slightly greater than the cross-sectional profile of each of the recesses 54. Thus, after the elastic engagement portion 56 is inserted into the recess 54 of the metal base 51, the outer surface of the elastic engagement portion 56 will be stably engaged with the inner surface of the recess 54 without being separated from each other. In addition, due to the principle of thermal expansion and contraction, when the metal base 51 and the elastic engagement portion 56 absorb more heat to expand their volume, the outer surface of the elastic engagement portion 56 will be in contact with the inner surface of the recess 54 more tightly, so as to substantially enhance the heat dissipation effect of the heat dissipation structure 50.

Besides, in other embodiments of the present invention, an acute angle smaller than 90° (such as 45°) or an obtuse angle greater than 90° (such as 120°) can be defined between each of the two heat dissipation portions 55 and each of the two ends of the elastic engagement portion 56. In other words, according to the heat dissipation portion 55 of the present invention, any predetermined bent angle can be defined between each of the heat dissipation portions 55 and each of the two ends of the elastic engagement portion 56, wherein the predetermine bent angle is not limited to 90°.

In addition, the cross-sectional profile of the metal base 51 is not limited to a cylindrical shape. In other embodiments of the present invention, the cross-sectional profile of the metal base 51 also can be elongated planar or of other profiles. According to the metal base 51 of the present invention, a metal base 51 with any cross-sectional profile can be formed by punching a one-piece metal plate or casting, wherein the cooling fins 52 are equidistantly arranged on the metal base 51 with any cross-sectional profile, and the outer surface of the elastic engagement portion 56 of each of the cooling fins 52 can be fixed on the outer surface of the metal base 51 with any cross-sectional profile. Furthermore, the metal base 51 can be used to receive various light emitting lamps, computer CPUs or other heat generating objects therein.

As described above, it should be noted that terms and descriptions in the foregoing embodiments (such as the profile of the cooling fins or the connection relationship between the cooling fins and the metal base) are only the preferred embodiments of the present invention, but not limited thereto.

The present invention has been described with the preferred embodiments thereof and it is understood that many changes and modifications to the described embodiments can be carried out without departing from the scope and the spirit of the invention that is intended to be limited only by the appended claims.

## Claims

1. A heat dissipation structure (40) having combined cooling fins (42), the heat dissipation structure (40) comprising:
a metal base (41) formed by punching a one-piece metal plate or casting, and having a first surface attached to a heat generating object and a second surface equidistantly formed with a plurality of recesses (44); and
a plurality of said cooling fms (42), each of which is formed by punching a one-piece metal plate or casting and includes two heat dissipation portions (45) and an elastic engagement portion (46), wherein each of the two heat dissipation portions (45) is a planar plate and the elastic engagement portion (46) is a U-shaped plate; two ends of the elastic engagement portion (46) having resilience and connected to one end of the two heat dissipation portions (45), respectively, and the two ends of the elastic engagement portion (46) being pressed to be close to each other, so that the elastic engagement portion (46) is deformable for being inserted and received in a corresponding said recess (44), while an outer surface of the elastic engagement portion (46) is allowed to be engaged with an inner surface of the recess (44) of the metal base (41) by the resilience of the elastic engagement portion (46), such that heat generated by the heat generating object is transferred from the metal base (41) to the cooling fins (42).

2. The heat dissipation structure (40) according to Claim 1, wherein a predetermined angle is defined between each of the heat dissipation portions (45) and each of the two ends of the elastic engagement portion (46).

3. A heat dissipation structure (50) having combined cooling fins (52), the heat dissipation structure (50) comprising:
a metal base (51) formed by punching a one-piece metal plate or casting, and having a receiving space (53) therein for receiving a heat generating object and an outer surface equidistantly formed with a plurality of recesses (54); and
a plurality of said cooling fins (52), each of which is formed by punching a one-piece metal plate to be a U-shaped structure and includes two heat dissipation portions (55) and an elastic engagement portion (56), wherein each of the two heat dissipation portions (55) is a planar plate and the elastic engagement portion (56) is a U-shaped plate; two ends of the elastic engagement portion (56) having resilience and connected to one end of the two heat dissipation portions (55), respectively, and the two ends of the elastic engagement portion being pressed to be close to each other, so that the elastic engagement (56) portion is deformable for being inserted and received in a corresponding said recess (54), while an outer surface of the elastic engagement portion (56) is allowed to be engaged with an inner surface of the recess (54) of the metal base (51) by the resilience of the elastic engagement portion (56), such that heat generated by the heat generating object is transferred from the metal base (51) to the cooling fins (52).

4. The heat dissipation structure (50) according to Claim 3, wherein a predetermined angle is defined between each of the heat dissipation portions (55) and each of the two ends of the elastic engagement portion (56).
